Europäisches Patentamt

European Patent Office

Office européen des brevets

(19)

(11) Numéro de publication : **0 463 972 A1**

# (12) DEMANDE DE BREVET EUROPEEN

(21) Numéro de dépôt : **91401764.5**

(22) Date de dépôt : **27.06.91**

(51) Int. Cl.$^5$ : **H01L 21/28,** H01L 21/339, H01L 27/088

(30) Priorité : **28.06.90 FR 9008167**

(43) Date de publication de la demande :
**02.01.92 Bulletin 92/01**

(84) Etats contractants désignés :
**DE ES GB IT**

(71) Demandeur : **COMMISSARIAT A L'ENERGIE ATOMIQUE**
**31-33, rue de la Fédération**
**F-75015 Paris (FR)**

(72) Inventeur : **Hartmann, Joel**
**22Bis, Chemin de Bellevue**
**F-38640 Claix (FR)**

(74) Mandataire : **Mongrédien, André et al**
**c/o BREVATOME 25, rue de Ponthieu**
**F-75008 Paris (FR)**

(54) **Procédé de fabrication d'un contact électrique sur un élément actif d'un circuit intégré MIS.**

(57)    Ce procédé de fabrication comprend les étapes suivantes : dépôt d'une couche épaisse (14) en un premier isolant électrique sur le circuit intégré pourvu de cet élément ; dépôt, sur la couche de premier isolant, d'une couche d'arrêt (28) en un matériau fortement résistif ou isolant apte à être gravé sélectivement par rapport au premier isolant et à un second isolant électrique ; réalisation, en regard de l'élément actif, d'une première ouverture dans la couche d'arrêt, fixant les dimensions, au niveau de l'élément actif (11) du contact électrique à réaliser ; dépôt sur la structure obtenue en c d'au moins une couche (30-16) de second isolant ; réalisation, en regard de la première ouverture, d'une seconde ouverture dans la couche de second isolant, la seconde ouverture ayant une largeur supérieure à celle de la première ouverture ; gravure du premier isolant mis à nu lors de l'étape e, en utilisant la couche d'arrêt gravée comme masque réalisant ainsi un trou de contact électrique (24b) de l'élément actif, et métallisation (22a) de ce trou de contact.

FIG. 3 E

La présente invention a pour objet un procédé de fabrication d'un contact électrique sur un élément actif d'un circuit intégré MIS. Elle s'applique à tout dispositif MIS ou MOS comportant au moins une grille de transistor et un contact électrique et en particulier dans le domaine des circuits intégrés du type nMOS, pMOS, CMOS et BICMOS et plus spécialement aux circuits intégrés de grande complexité où la diminution des motifs est nécessaire. Ces circuits sont en particulier des mémoires à semi-conducteurs, des microprocesseurs, des microcontrôleurs.

Avec la réduction des dimensions critiques des circuits intégrés et plus particulièrement de la dimension des grilles des transistors MOS, les transistors de type n et aussi de type p sont maintenant réalisés avec un procédé à double implantation notée LDD permettant notamment de résoudre les problèmes de perçage entre la source et le drain de ces transistors.

Ce procédé à double implantation est essentiellement utilisé pour des circuits intégrés dont les dimensions des grilles sont inférieures à 2µm.

Le procédé de l'invention étant parfaitement bien adapté aux circuits à transistors LDD, la description de l'art antérieur qui suit ne concerne que ces circuits intégrés. Toutefois, l'invention s'applique aussi aux transistors à simples jonctions.

L'illustration de transistors à doubles jonctions est ici justifiée par le fait que l'invention s'adresse plus particulièrement à une technologie submicronique qui nécessite, pour des raisons de fiabilité, ce type de jonction mais l'on pourrait, bien entendu, raisonner avec des transistors à simples jonctions.

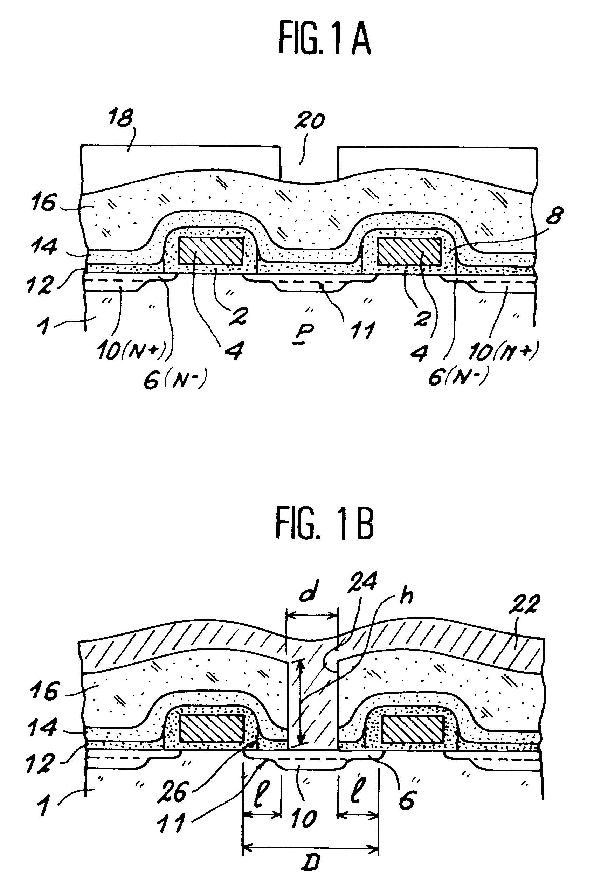

Sur les figures 1A et 1B, on a représenté schématiquement, en coupe longitudinale, les différentes étapes de fabrication d'un contact électrique et du trou de contact correspondant selon l'art antérieur, situé entre deux grilles de transistor MOS d'un circuit intégré. Ces transistors sont des transistors à canal N, réalisés sur un substrat en silicium monocristallin de type P.

La figure 1A montre une coupe du circuit intégré après réalisation, sur le substrat 1, de l'isolant de grille 2 et des grilles 4 en silicium polycristallin des transistors MOS, formation des régions 6 de type N- des régions de source et drain, formation des espaceurs 8 sur les flancs des grilles 4, puis formation des régions 10 de type N+ des sources et drains des transistors. La référence 11 indique la zone active sur laquelle on veut réaliser le contact électrique.

Après une réoxydation thermique 12 des régions de sources et drains et des grilles 4, de quelques dizaines de nanomètres, on dépose un isolant électrique bicouche constitué d'une couche d'oxyde de silicium 14 intrinsèque ou non dopé, de 0 à 100 nm d'épaisseur, et d'une couche d'oxyde 16 dopé au phosphore, tel que du PSG (verre silicaté dopé au phosphore) ou dopé au bore et au phosphore tel que du BPSG (verre silicaté dopé au bore et au phosphore).

La couche 14 non dopée sert à limiter la diffusion du bore ou du phosphore dans la grille où les jonctions des transistors MOS. Son utilisation n'est donc pas nécessaire, puisque la réoxydation thermique 12 suffit à remplir ce rôle.

L'ensemble des couches isolantes 12, 14 et 16 assure l'isolement électrique entre grille et source (ou drain).

On effectue ensuite un traitement thermique destiné à faire fluer la couche d'isolant 16 puis on forme par photolithographie un masque 18 de résine permettant de définir l'emplacement et les dimensions du trou de contact à réaliser. Ce masque 18 est positionné par rapport aux grilles 4 des transistors ou par rapport aux zones actives 6-10 ; l'ouverture 20 du masque délimitant le trou de contact à réaliser est située en regard de la zone active 11.

On effectue alors une gravure anisotrope des couches 16, 14 et 12 jusqu'à mise à nu de la zone active 11 du substrat 1, comme représenté sur la figure 1B, puis le dépôt d'une couche métallique 22 destinée à former le contact électrique.

Les techniques de photolithographie actuelles permettent d'imprimer au mieux dans la résine 18 des ouvertures 20 de 0,8µm de diamètre. Mais compte tenu de l'épaisseur de l'isolant à graver, le diamètre final d du trou de contact électrique 24 est généralement plus large que celui de l'ouverture 20, typiquement de l'ordre de 1µm.

Pour éviter tout risque de court-circuit, par le trou de contact 24, entre les grilles 4 des transistors et la métallisation 22, il est nécessaire d'appliquer une garde minimum 26 entre les flancs des grilles et le bord du trou de contact 24. Cette garde tient compte de la tolérance de positionnement (ou alignement) entre le trou de contact 24 et les grilles et permet de maintenir une épaisseur minimum d'isolant entre les deux. Dans le cas présent, la largeur l des gardes 26 est au mieux de 0,8um.

Dans ces conditions, on voit que la dimension minimum D entre deux grilles séparées par un contact est de 2,6µm. Cette distance minimum n'est en outre possible que si le remplissage du trou de contact 24 peut être réalisé lors de la métallisation 22 par une technique de dépôt conforme.

Le remplissage du trou de contact 24 ne peut nullement être réalisé de façon conventionnelle à l'aide d'un dépôt d'aluminium ou d'un alliage d'aluminium par pulvérisation cathodique. En effet, ces matériaux présentent une mauvaise couverture de marche dans un trou dont la hauteur h est supérieure à son diamètre d, entraînant un mauvais remplissage du trou de contact et éventuellement des discontinuités électriques.

Le remplissage du trou de contact, comme représenté sur la figure 1B, peut être réalisé par exemple, en déposant du tungstène par CVD (dépôt chimique en phase vapeur).

En effet, ce matériau se dépose avec la même épaisseur sur les parties horizontales (fond du trou et dessus isolant 16) et verticales (flancs du trou), ce qui lui permet de remplir entièrement le trou de contact.

L'utilisation de tungstène déposé par CVD pour la réalisation de contact est décrite dans l'article de C. Kaanta et al. "Submicron wiring technology with tungsten and planarization", V. MIC Conf. 1988 13-14 juin, CH-2624-5-1988, p. 21-28.

Ce dépôt de tungstène peut soit être gravé de façon à ne conserver que du tungstène dans le trou de contact, les lignes d'interconnexion électrique étant alors réalisées par dépôt sur l'ensemble du circuit, puis gravure d'une couche d'aluminium, soit être gravé de façon à y réaliser les lignes d'interconnexion.

Malheureusement, les techniques de dépôt et de gravure du tungstène requises pour les dispositifs submicroniques ne sont actuellement qu'en cours d'étude et de développement et très peu utilisées industriellement.

Par ailleurs, le tungstène présente une résistivité élevée et en particulier trois fois plus grande que celle de l'aluminium, ce qui pose des problèmes de vitesse de propagation des informations dans le circuit intégré.

Enfin, la réalisation des contacts électriques et des lignes d'interconnexion en deux matériaux conducteurs complique quelque peu le procédé de fabrication des circuits intégrés, augmentant ainsi leur coût de fabrication.

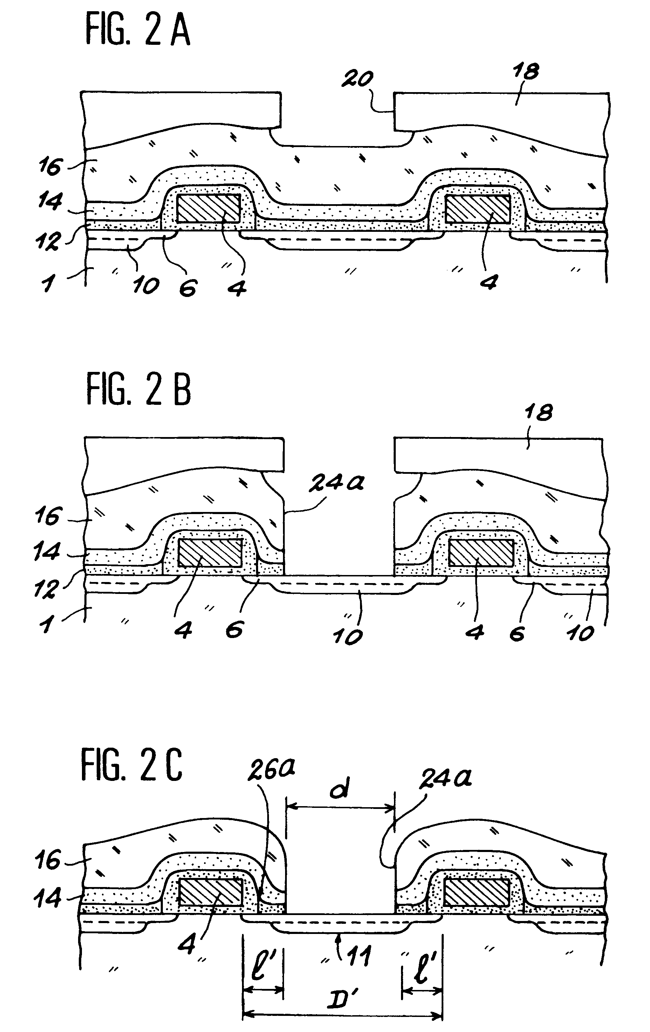

Pour conserver une métallisation conventionnelle en aluminium, il est nécessaire de modifier le procédé décrit précédemment. Ce procédé modifié est représenté schématiquement, en coupe longitudinale, sur les figures 2A à 2C. Ce procédé a pour but d'élargir la partie supérieure du trou de contact électrique pour permettre une bonne couverture de ce dernier par l'aluminium.

Après réalisation du masque 18, on effectue tout d'abord une gravure isotrope de la couche d'isolant 16 sur la moitié de son épaisseur, comme représenté sur la figure 2A, afin d'obtenir un trou de contact 24a en forme d'entonnoir, évasé dans sa partie supérieure. En effet, une gravure isotrope permet une attaque de l'isolant 16 débordant de part et d'autre de l'ouverture 20 du masque 18.

On effectue ensuite une gravure anisotrope des couches 16, 14 et 12 jusqu'au substrat 1. La structure est celle représentée sur la figure 2B. On élimine ensuite le masque de résine 18 puis on érode l'isolant 16, de façon à obtenir la structure représentée sur la figure 2C.

Ce procédé, connu sous le nom de facettage des contacts est en particulier décrit dans le document V-MIC Conf. du 15-16 juin 1987, CH-2488-5-1987 IEEE p.298-305, "Contact hole and via profiling by high rate isotropic and anisotropic etching of oxides" de V. Grewal et al.

Malheureusement, ce procédé conduit encore à un agrandissement des gardes 26a entre les grilles 4 des transistors et le contact électrique 24a. Dans le cas décrit ci-dessus, la largeur l' des gardes est de 1$\mu$m, ce qui conduit à une dimension D' entre les deux grilles séparées par un contact de 3$\mu$m. Ceci va à l'inverse de l'augmentation de la densité d'intégration des circuits intégrés.

L'invention a pour objet un procédé de fabrication d'un contact électrique sur un élément actif d'un circuit MIS permettant de remédier aux inconvénients ci-dessus. En particulier elle permet de réduire la distance contact-grilles d'un transistor MIS tout en élargissant la partie supérieure du trou de contact et permettant ainsi de conserver une métallurgie conventionnelle en aluminium. La réduction de la distance entre le contact et la grille permet d'augmenter la densité d'intégration du circuit correspondant.

L'invention s'applique à chaque fois que l'on désire connecter une zone active (source ou drain) ou une grille d'un transistor MIS d'un circuit intégré à une autre zone active ou grille d'un composant actif du circuit. De plus, ce transistor peut être un transistor à simples ou doubles jonctions.

De façon plus précise, l'invention a pour objet un procédé de fabrication d'un contact électrique sur un élément actif d'un circuit intégré MIS, comprenant les étapes suivantes :

a) - dépôt d'une couche épaisse en un premier isolant électrique sur le circuit intégré ;

b) - dépôt, sur la couche de premier isolant, d'une couche d'arrêt en un matériau fortement résistif ou isolant apte à être gravé sélectivement par rapport au premier isolant et à un second isolant électrique ;

c) - réalisation, en regard de l'élément actif, d'une première ouverture dans la couche d'arrêt, fixant les dimensions, au niveau de l'élément actif du contact électrique à réaliser ;

d) - dépôt sur la structure obtenue en c d'au moins une couche de second isolant ;

e) - réalisation, en regard de la première ouverture, d'une seconde ouverture dans la couche de second isolant, la seconde ouverture ayant une largeur supérieure à celle de la première ouverture ;

f) - gravure du premier isolant mis à nu lors de l'étape e, en utilisant la couche d'arrêt gravée comme masque réalisant ainsi un trou de contact électrique de l'élément actif, et

g) - métallisation de ce trou de contact.

Par élément actif, il faut comprendre une grille, un drain ou une source d'un transistor MIS.

Dans le procédé conforme à l'invention, la largeur réelle du contact électrique sur la zone active est définie par la largeur de la première ouverture.

La largeur supérieure du contact électrique est définie par la largeur de la seconde ouverture et peut être nettement plus large, permettant ainsi un bon remplissage de la structure par une métallurgie conventionnelle, sans risque de court-circuit notamment avec la grille des transistors, grâce à la présence de la couche d'arrêt qui permet de conserver l'épaisseur du premier isolant tout autour de la grille.

Ainsi, il est possible d'utiliser de l'aluminium ou un alliage à base d'aluminium pour la métallisation du trou de contact. Par exemple, on peut utiliser un alliage d'aluminium et de silicium ou un alliage d'aluminium et de cuivre que l'on dépose par pulvérisation cathodique.

La couche d'arrêt de gravure permet en outre de réduire la distance entre le contact et la grille du transistor puisque le facettage du contact électrique s'effectue sans affecter l'épaisseur du premier isolant.

Dans le cas d'une gravure anisotrope du premier isolant, le contrôle de la largeur du trou de contact dans sa partie inférieure est beaucoup plus précis que dans l'art antérieur puisqu'il est réalisé dans une couche d'arrêt de faible épaisseur. Ceci permet donc de réduire également la distance contact-grille.

Le rôle du premier isolant dans un transistor MIS est d'assurer l'isolation électrique entre les zones actives (source et drain) et la grille de ce transistor. Son épaisseur doit donc être importante pour assurer cet isolement électrique et notamment pour réduire la capacité parasite entre les différentes connexions du transistor. Typiquement, cette couche doit avoir une épaisseur minimum de 200nm et une épaisseur maximum de 600nm.

L'invention s'applique à un grand nombre de substrats semi-conducteurs tels que le silicium dopé du type n ou p, le GaAs, l'InP, le HgCdTe, etc. Toutefois, l'invention est parfaitement bien adaptée à la technologie silicium.

Les isolants électriques peuvent être réalisés en un grand nombre de matériaux, tels que l'oxyde de silicium non dopé, le nitrure de silicium, l'oxynitrure de silicium, des verres silicatés dopés au phosphore ou des verres borosilicatés dopés au phosphore. On peut même utiliser certains polymères isolants. Le premier isolant est en particulier réalisé en oxyde de silicium non dopé en nitrure ou oxynitrure de silicium.

Par ailleurs, la couche d'arrêt peut être réalisée en silicium polycristallin, en nitrure de silicium, en oxynitrure de silicium ou en oxyde de silicium. Lorsque le premier isolant est de l'oxyde de silicium, la couche d'arrêt est avantageusement réalisée en nitrure de silicium ou en silicium polycristallin intentionnellement non dopé.

Lorsque la couche d'arrêt est en silicium polycristallin, le second isolant est avantageusement constitué par un isolant bicouche et en particulier par une couche d'oxyde de silicium non dopé surmontée de BPSG. L'utilisation d'un oxyde non dopé entre la couche d'arrêt en silicium et l'oxyde dopé, permet d'éviter tout risque de dopage du silicium par le BPSG. En effet, le silicium polycristallin doit rester très résistif pour éviter tout risque de courant de fuite entre deux contacts adjacents à des potentiels différents.

Le procédé de l'invention s'applique à tous types de contacts à réaliser et en particulier des contacts sur les zones actives telles que les sources et drains des transistors ou même sur les grilles de ces transistors. En outre, ces transistors peuvent être monogrille ou multigrille (cas des mémoires EPROM par exemple) à simples ou doubles jonctions.

D'autres caractéristiques et avantages de l'invention ressortiront mieux de la description qui va suivre, donnée à titre illustratif et non limitatif.

La description est faite en référence aux dessins annexés dans lesquels :
– les figures 1A-1B et 2A-2C, déjà décrites, représentent schématiquement en coupe longitudinale, les différentes étapes de fabrication selon l'art antérieur d'un contact électrique entre deux transistors MOS à doubles jonctions, et
– les figures 3A-3F représentent schématiquement en coupe longitudinale les différentes étapes de fabrication selon l'invention d'un contact électrique entre deux transistors MOS à doubles jonctions.

La description qui suit se rapporte à la fabrication d'un transistor à effet de champ MOS à doubles jonctions, à canal n, dans un substrat en silicium de type p. Mais, bien entendu, comme on l'a vu précédemment, l'invention est d'application beaucoup plus générale.

Les éléments inchangés par rapport à l'art antérieur décrit précédemment porteront les mêmes références.

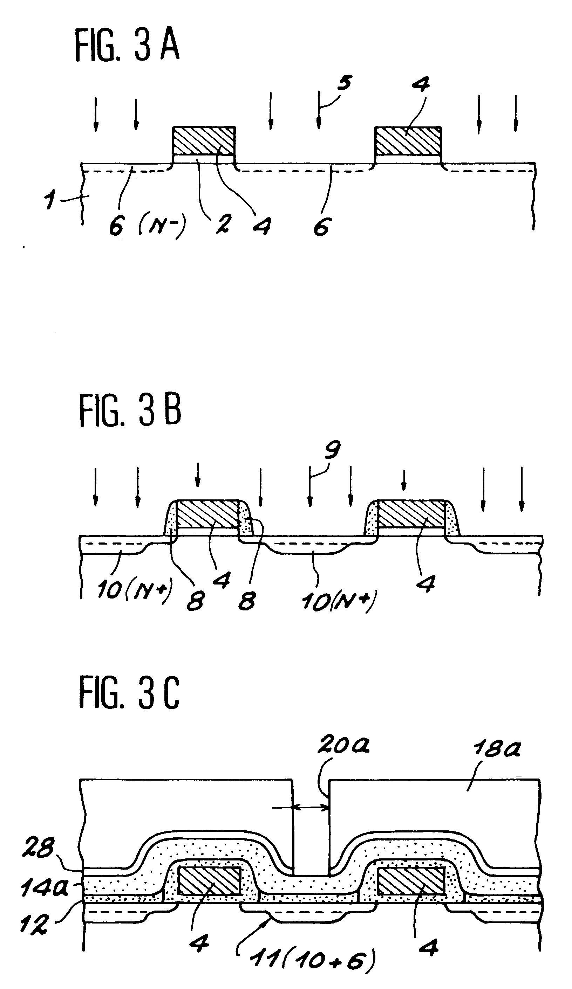

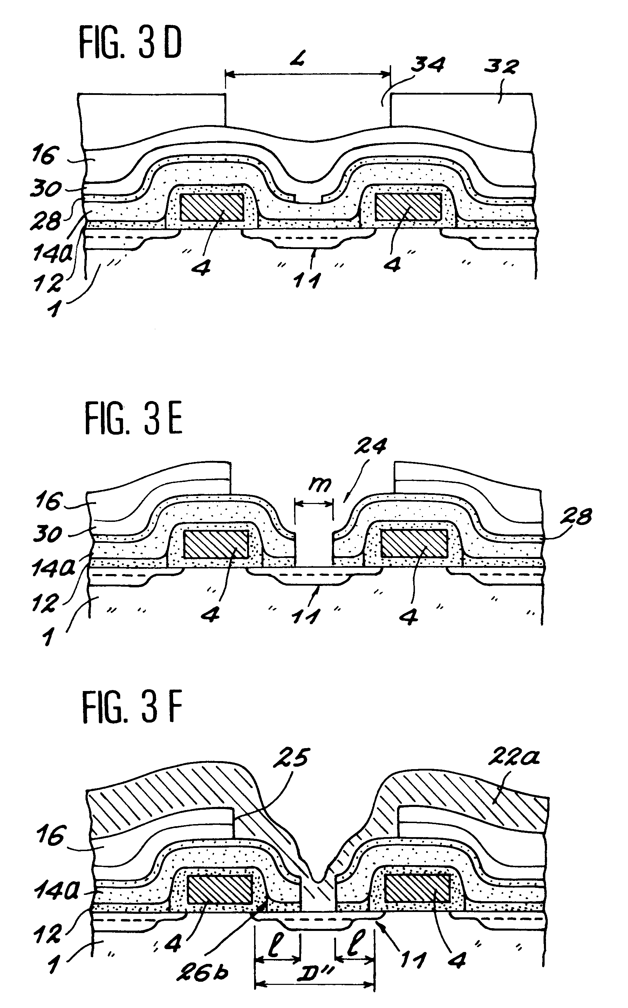

Comme représenté sur la figure 3A et conformément à l'art antérieur, on forme tout d'abord sur le substrat 1 en silicium monocristallin de type p l'oxyde de grille 2 des transistors MOS par oxydation thermique du substrat. Il présente une épaisseur de 20nm environ.

On dépose ensuite une couche de silicium polycristallin dopé au phosphore à une concentration de 5 à 10% en poids, par CVD. Cette couche présente une épaisseur de 400nm environ.

On réalise ensuite une photogravure du silicium polycristallin fixant les dimensions des grilles 4 des transistors. En particulier, elles présentent une largeur inférieure à 2μm, mesurée selon le plan de la figure 3A.

On effectue ensuite une implantation 5 d'ions de type n, à faible dose, par exemple de phosphore à une énergie de 60keV et une dose de $10^{13}$ions/cm$^2$, en utilisant les grilles 4 comme masque à cette implantation, conduisant à la formation des régions 6 de type N- constituant les premières jonctions des régions de source et drain.

On forme alors, comme représenté sur la figure 3B, les espaceurs 8 sur les flancs latéraux des grilles 4, présentant une largeur à la base d'environ 200 à 300nm et ayant pour rôle de repousser l'implantation à forte dose des bords des grilles de chaque transistor. Ces espaceurs sont par exemple réalisés en oxyde de silicium.

Ils sont obtenus classiquement par dépôt isotrope d'une couche d'oxyde, puis gravure pleine plaque anisotrope de cette couche.

On effectue alors une implantation 9 d'ions de type n, à forte dose, par exemple d'arsenic à une dose de $5 \times 10^{15}$ ions/cm$^2$ et une énergie de 100keV, en utilisant les grilles 4 et les espaceurs 8 comme masque à cette implantation. On obtient ainsi deux régions 10 de type N+ de part et d'autre des grilles des transistors, sous les régions 6, constituant ainsi les doubles jonctions des transistors MOS.

On effectue ensuite, comme représenté sur la figure 3C, l'isolation électrique 12 de l'ensemble du circuit consistant en une réoxydation thermique des régions de source et drain 6-10 et des grilles 4. Cet isolant a une épaisseur de 10 à 20nm environ sur les régions de source et drain.

On dépose ensuite une couche 14a d'oxyde de silicium intrinsèque ou non intentionnellement dopé sur l'ensemble du circuit, constituant le premier isolant. Cette couche 14a a pour rôle d'assurer l'isolation électrique entre la grille du transistor et respectivement la source et le drain. Ce dépôt peut être réalisé par dépôt chimique en phase vapeur à pression atmosphérique (APCVD) ou par dépôt chimique en phase vapeur à basse pression (LPCVD) par pyrolyse de tétraéthylorthosilicate (TEOS) à 800°C.

Conformément à l'invention, cette couche 14a est plus épaisse que la couche 14 de l'art antérieur car elle définit l'épaisseur minimum d'isolant entre le bord des grilles 4 et le contact électrique à réaliser. En particulier, cette couche a une épaisseur de 300nm au lieu de 100 nm au maximum dans l'art antérieur.

Conformément à l'invention, on dépose ensuite une couche d'arrêt 28 par exemple en silicium polycristallin intrinsèque ou en nitrure de silicium, de 50nm d'épaisseur. Cette couche est déposée par LPCVD.

On réalise ensuite par photolithographie un premier masque de résine 18a comportant une ouverture 20a définissant l'emplacement et les dimensions du contact électrique à réaliser, au niveau de la zone active 11. Ce masque 18a est positionné (ou aligné) par rapport aux grilles 4 des transistors. En particulier, l'ouverture 20a est située en regard de la zone active 11 située entre les grilles 4 des transistors. L'ouverture 20a présente par exemple un diamètre m de 0,8µm.

On effectue alors une gravure sélective de la couche 28 par rapport à l'isolant 14a, par exemple une gravure ionique réactive avec du gaz SF$_6$ pour la couche 28 en silicium polycristallin, afin d'éliminer la région de la couche 28 non masquée. L'arrêt de gravure s'effectue sur la couche 14a.

On élimine ensuite le masque 20a par exemple à l'aide d'un plasma d'oxygène.

On effectue alors, comme représenté sur la figure 3D, le dépôt d'une couche d'isolant 30 en un oxyde intentionnellement non dopé et en particulier en oxyde de silicium intrinsèque. Cette couche 30 a par exemple une épaisseur de 100nm et est déposée en particulier par APCVD ou LPCVD par pyrolyse de TEOS à 800°C.

On dépose ensuite la couche d'isolant 16 constituée en particulier de verre silicaté dopé au bore et au phosphore (BPSG) par APCVD à 430°C. Cette couche 16 a par exemple une épaisseur de 500nm.

La couche isolante 30 non dopée permet d'éviter la diffusion du bore ou du phosphore du verre BPSG constituant la couche 16 dans le silicium polycristallin de la couche 28, cette dernière devant rester électriquement très résistive.

On effectue ensuite un recuit thermique de la couche 16 de façon à réaliser un fluage de celle-ci. Ce recuit peut être réalisé dans un four à 900°C ou à l'aide de lampes à 1050°C. Le recuit par lampe est un recuit rapide connu généralement sous l'abréviation RTP.

On réalise ensuite par photolithographie un second masque de résine 32 sur la couche 16 comportant une ouverture 34 située en regard de la zone active 11 sur laquelle sera réalisé le contact électrique. Le diamètre ou largeur L de l'ouverture 34 est plus large que l'ouverture 20a du premier masque 18a. Cette ouverture 34 peut en particulier déborder sur les grilles des transistors MOS.

La largeur L ou diamètre de l'ouverture 34 est par exemple supérieure ou égale à 1,8µm au lieu de 0,8µm pour l'ouverture 20a. La distance minimum 1,8µm correspond en fait à la distance séparant les deux grilles 4, si la distance du bord de grille à l'ouverture 20a est réduite à 0,5 µm.

La couche 14a d'isolant permet donc de faire déborder l'ouverture 34 du masque 32 sur les grilles 4 des transistors tout en maintenant une épaisseur constante d'isolant tout autour de ces grilles ; ceci ne serait pas possible en l'absence de cette couche 14a. En outre, cette couche 14a permet de garantir une épaisseur d'isolant suffisante entre le coin des grilles et le coin du premier contact électrique, si celui-ci est désaligné par rapport à la grille ; ceci permet donc aussi de réduire la distance (l) contact-grille fixée par le masque 18a.

On effectue alors une gravure des couches 16, 30, 14a et 12 jusqu'au substrat 1 afin de mettre à nu la zone active 11 sur laquelle on veut former le contact électrique. La structure obtenue est celle représentée sur la figure 3E. Le trou de contact obtenu porte la référence 24b.

La gravure de cet empilement de couches d'oxyde doit être réalisée sélectivement par rapport au silicium 1 (sélectivité supérieure à 10). Cette gravure peut être une gravure ionique réactive en utilisant un mélange de gaz $CHF_3$-$C_2F_6$ lorsque toutes les couches isolantes sont des oxydes de silicium.

On effectue ensuite l'élimination du masque 32 par plasma d'oxygène.

Conformément à l'invention, les dimensions du trou de contact 24b ainsi formé sur la zone active 11 sont fixées par celles de l'ouverture 20a du masque 18a. Etant donné les épaisseurs respectives des couches 12 et 14a, on obtient un trou de contact de largeur m identique à celle de l'ouverture 20a et par exemple égale à 0,8μm. Les dimensions et notamment la largeur du trou de contact 24b sont donc bien contrôlées.

Le contact électrique peut alors être réalisé par dépôt d'une couche 22a à base d'aluminium et par exemple d'un alliage de cuivre et d'aluminium par pulvérisation cathodique. Cette couche 22a a une épaisseur d'environ 800nm.

Grâce à l'élargissement 25 du trou de contact 24b dans sa partie supérieure, la couche 22a à base d'aluminium remplit bien le trou de contact.

La couche 22a peut alors être gravée de façon à réaliser la ligne conductrice destinée à la connexion de la zone active 11 avec d'autres zones actives.

Le procédé de l'invention permet en outre de réduire les gardes 26b jusqu'à une largeur de 0,5μm. Ainsi, la distance D″ séparant les deux grilles 4 est ramenée à 1,8μm, ce qui permet d'augmenter la densité d'intégration des circuits par rapport à l'art antérieur.

**Revendications**

1. Procédé de fabrication d'un contact électrique sur un élément actif d'un circuit intégré MIS, comprenant les étapes suivantes :

   a) - dépôt d'une couche épaisse (14) en un premier isolant électrique sur le circuit intégré, pourvu de cet élément ;
   b) - dépôt, sur la couche de premier isolant, d'une couche d'arrêt (28) en un matériau fortement résistif ou isolant apte à être gravé sélectivement par rapport au premier isolant et à un second isolant électrique ;
   c) - réalisation, en regard de l'élément actif, d'une première ouverture dans la couche d'arrêt (figure 3d), fixant les dimensions, au niveau de l'élément actif (11) du contact électrique (22) à réaliser ;
   d) - dépôt sur la structure obtenue en c d'au moins une couche (30-16) de second isolant ;
   e) - réalisation, en regard de la première ouverture, d'une seconde ouverture (25) dans la couche de second isolant, la seconde ouverture ayant une largeur supérieure à celle de la première ouverture ;
   f) - gravure du premier isolant mis à nu lors de l'étape e, en utilisant la couche d'arrêt gravée comme masque réalisant ainsi un trou de contact électrique (24b) de l'élément actif, et
   g) - métallisation (22a) de ce trou de contact.

2. Procédé selon la revendication 1, caractérisé en ce que la métallisation est en aluminium ou en un alliage d'aluminium.

3. Procédé selon la revendication 1 ou 2, caractérisé en ce que le premier isolant a une épaisseur de 200 à 600 nm.

4. Procédé selon l'une quelconque des revendications 1 à 3, caractérisé en ce que le circuit intégré est réalisé sur un substrat en silicium, en ce que l'on oxyde ce substrat juste avant de déposer la couche en premier isolant et en ce que l'on grave cet oxyde au cours de l'étape f).

5. Procédé selon l'une quelconque des revendications 1 à 4, caractérisé en ce que le premier et le second isolants sont en oxyde de silicium et la couche d'arrêt en nitrure de silicium ou en silicium polycristallin non intentionnellement dopé.

6. Procédé selon la revendication 5, caractérisé en ce que le second isolant est un matériau bicouche (30, 16) dont la couche inférieure (30) est en oxyde de silicium non dopé et la couche supérieure en oxyde de silicium dopé au phosphore et/ou au bore.

7. Procédé selon l'une quelconque des revendications 1 à 6, caractérisé en ce que l'élément actif est une zone active d'un transistor MIS.

8. Procédé selon l'une quelconque des revendications 1 à 7, caractérisé en ce qu'il comprend les étapes suivantes :

   1) - dépôt de la couche épaisse (14) de premier isolant ;
   2) - dépôt de la couche d'arrêt (28) sur la couche de premier isolant ;
   3) - réalisation d'un premier masque de gravure (18a) sur la couche d'arrêt, comportant une ouverture (20a) en regard de l'élément actif, dont la largeur fixe celle du contact au niveau dudit élément, puis
   4) gravure de la couche d'arrêt ;
   5) élimination du premier masque de gravure ;
   6) dépôt sur la structure obtenue en 5) de la couche (30-16) de second isolant ;

7) - réalisation d'un second masque de gravure (32), sur la couche de second isolant comportant une ouverture (34) en regard de l'élément actif, dont la largeur est supérieure à celle de l'ouverture du premier masque ;

8) - gravure de la couche de second isolant puis de premier isolant réalisant ainsi le trou de contact (24b), et

9) - métallisation du trou de contact.

# FIG. 1 A

# FIG. 1 B

# FIG. 2 A

# FIG. 2 B

# FIG. 2 C

9

# FIG. 3 A

# FIG. 3 B

# FIG. 3 C

# FIG. 3 D

L

34   32

16
30
28
14α
12
1

4   11   4

# FIG. 3 E

24

m

16
30
14α
12
1

28

4   11   4

# FIG. 3 F

25   22a

16

14α

12
1

4   26b   ℓ   D"   ℓ   11   4

Office européen
des brevets

# RAPPORT DE RECHERCHE EUROPEENNE

Numero de la demande

EP 91 40 1764

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|-----------|--------------------------------------------------------------------------------|------------------------|----------------------------------------|
| A | US-A-4299862 (GENERAL MOTORS CORPORATION) <br> * abrégé * <br> --- | 1 | H01L21/28 <br> H01L21/339 <br> H01L27/088 |
| A | EP-A-155699 (NEC CORPORATION) <br> * abrégé * <br> ----- | 1 | |

**DOMAINES TECHNIQUES RECHERCHES (Int. Cl.5 )**

H01L21

Le présent rapport a été établi pour toutes les revendications

| Lieu de la recherche | Date d'achèvement de la recherche | Examinateur |
|----------------------|-----------------------------------|-------------|
| LA HAYE | 09 SEPTEMBRE 1991 | PHEASANT N.J. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)